# Europäisches Patentamt
## European Patent Office
## Office européen des brevets

(11) Publication number: **0 035 334**
**B1**

(12) **EUROPEAN PATENT SPECIFICATION**

(45) Date of publication of patent specification: **25.09.85**

(51) Int. Cl.⁴: **G 06 F 9/26**

(21) Application number: **81300560.0**

(22) Date of filing: **11.02.81**

(54) Data processing system with two level microprogramming.

(30) Priority: **11.02.80 US 120272**
**11.02.80 US 120271**
**11.02.80 US 120291**
**11.02.80 US 120292**

(43) Date of publication of application:
**09.09.81 Bulletin 81/36**

(45) Publication of the grant of the patent:
**25.09.85 Bulletin 85/39**

(84) Designated Contracting States:
**CH DE FR GB IT LI NL SE**

(56) References cited:
DE-A-1 958 662
DE-A-2 510 766
DE-B-1 082 947
GB-A-1 433 076
US-A-3 217 267
US-A-3 786 434
US-A-4 000 485
US-A-4 081 755
US-A-4 084 082
US-A-4 131 943

(73) Proprietor: **DATA GENERAL CORPORATION**
**Route 9**
**Westboro Massachusetts 01581 (US)**

(72) Inventor: **Bernstein, David H.**
**41 Bay Colony Drive**
**Ashland Massachusetts 01721 (US)**
Inventor: **Carberry, Richard A.**
**10082 Firwood Drive**
**Cupertino California 95014 (US)**
Inventor: **Druke, Michael B.**
**32 Longmeadow Road**
**Chelmsford Massachusetts 01824 (US)**
Inventor: **Gusowski, Ronald I.**
**5 Baxter Street**
**Westboro Massachusetts 01581 (US)**
Inventor: **Buckley, Edward M.**
**68 Dutcher Street**
**Hopedale Massachusetts 01747 (US)**
Inventor: **March, Roger W.**
**3422 Georgetown Place**
**Santa Clara California 95051 (US)**

(74) Representative: **Pears, David Ashley et al**
**REDDIE & GROSE 16 Theobalds Road**
**London WC1X 8PL (GB)**

Courier Press, Leamington Spa, England.

(56) References cited:
**US-A-4 148 011**
**US-A-4 186 379**

**ELECTRONICS, vol. 51, no. 23, November 1978,
pages 125-129, New York, U.S.A., HEDGES:
"Replacing hardwired logic with microcode"
IEEE TRANS. ON NUCLEAR SCIENCE, vol.
NS-26, no. 4, August 1979, pages 4525-4530,
New York, U.S.A., R.W. DOWNING: "Fastbus -
Details of addressing and bus mastership"
IEEE TRANS. ON NUCLEAR SCIENCE, vol.
NS-26, no. 1, February 1979, pages 679-685,
New York, U.S.A., R.S. LARSEN: "Status of the
interlaboratory development of a high-speed
standard data bus - Fastbus"
IEEE COMPUTER SOCIETY INTERNATIONAL
CONFERENCE, COMPCON 75, 25th-27th
February 1975, pages 27-30, San Francisco,
New York, U.S.A., A. BAUM et al.: "Hardware
considerations in a microcomputer
multiprocessing system"**

# 0 035 334

**Description**

This invention relates to a data processing system comprising a central processing unit with a first control memory and addressing means therefor responsive to a microinstruction to provide a sequence of first microinstructions, each including an address field and one or more modifier fields, a second control memory responsive to each said address field to provide a second microinstruction and means responsive to the corresponding modifier field(s) to effect modification of the second microinstruction.

It is known, in data processing systems, to use macroinstructions which are suitably decoded so as to provide access to a microinstruction or to a sequence of more than one microinstruction obtained from a suitable data store thereof.

Generally, in such systems, for example, a macroinstruction is appropriately supplied from a macroinstruction register to suitable decoding logic so as to provide a starting address for access in the microinstruction data store (sometimes referred to as the microcode store) of an initial microinstruction of a sequence thereof. The accessed microinstruction includes control information for performing the instruction designated and sequence information for determining the microaddress of the next microinstruction of the sequence. Each sequential microinstruction contains the same kind of information until the last microinstruction of the sequence has been accessed at which point the microinstruction routine having been completed, the system is ready to decode the next macroinstruction.

Such systems normally require a relatively large microcode data store utilizing microinstruction words which are relatively wide (i.e. they contain a relatively large number of bits) so as to contain the required control and sequencing information. While the use of relatively wide microinstruction words provides higher speed operation (i.e. a larger number of bits are simultaneously available in parallel to provide the control and sequencing operations such systems tend to be more costly not only because the number of storage bits in microcode data store becomes relatively high but the data paths for handling a wide microinstruction word becomes more complex and the system requires more expensive components and data path configurations.

In order to reduce the data storage space required for the microinstructions and to avoid handling a large number of "wide" instruction words, certain microcode systems have utilized "two-level" microcode store techniques as opposed to one level microcode stores as discussed above. Such two-level configurations arise from the recognition that control information in the microinstruction words are often common to a large number of the microinstructions. Therefore, in order to avoid the repetitive storage of the same relatively large number of data bits required to store all of the control and sequencing information for each microinstruction separately, control information, which is common to many microinstructions, is stored in one ROM store separately from sequencing information which is stored in a different ROM store. At this "first level" of operation the sequencing process is performed at the sequence microcode store ROM to produce sequential addresses to access control information in the control microcode store ROM which at the "second level" of operation provides the control information required to sequentially perform the particular microinstruction involved, which latter information may be common to many micro-instructions.

A system as set forth in the first paragraph above is known from US—A—3 786 434. (Frye a.V.) A first level memory stores address fields and control and mask fields. A micro-routine is performed by accessing a sequence of the address fields to address in turn a second level memory providing the microinstructions to be executed. Each mask field is made up of mask bits which select which fields of each microinstruction are actually sent to be decoded for execution. Each control field is made up of one-bit fields which it is unnecessary to store in the second level memory. These one bit fields supplement the fields of the microinstruction from the second level memory.

The mask fields provide some flexibility in that a relatively large number of microinstructions may be formed from a smaller number of microinstructions in the second level memory. The control fields provide no additional flexibility, it is merely a question of which memory stores the one-bit fields.

Another known system US—A—4 131 943 (Shiraogawa) uses a first level memory which stores a starting address for a sequence of microinstructions stored in a second memory and a control bit which changes the operating mode to another for the sequence of microinstructions. However each such sequence is fixed in the second level memory and the degree of flexibility given by the control bit is very limited.

The object of the present invention is to enable a significantly higher degree of flexibility to be achieved and the invention is characterised in that the modifying means substitute one or more of the fields of selected second microinstructions by a modifier field in accordance with a predetermined scheme of substitutions as specified by the substituted field or fields, in which scheme each modifier field selectively effects a plurality of different modifying substitutions.

The modifier fields may now be multibit fields which selectively replace fields of the second microinstructions and preferably each second microinstruction itself determines which fields thereof are replaced. In the preferred embodiment there are two modifier fields $V_1$ and $V_2$, both of which modify a variety of fields, depending upon which second microinstruction is in question.

Thus the invention provides a capability for greatly expanding the microinstruction set without increasing the size of the microcode control store. In accordance therewith, the preferred system includes

3

what has been termed an "orthogonal" microcontrol store in which a first, or "vertical", microcontrol store provides a "narrow" microinstruction word portion having one field comprising a selected number of vertical microinstruction bits for selecting one of a plurality of second or "horizontal" microinstructions from a second level, or horizontal, microcontrol store, one or more "modifier" fields, as described more fully below, and a sequencing field for presenting the address of the next (i.e., each successive) vertical microinstruction in a sequence thereof. Each horizontal microinstruction represents a basic function to be performed but, unlike prior systems, one or more of the fields thereof are subject to modification by the modifier field of the vertical microinstructions. For example, prior two-level systems use a vertical sequence store which merely specifies the address of a particular control word in a horizontal control store, the control word requiring the movement of data from a first specified register (e.g., general register GR1) to a second specified register (e.g., general register GR2). In contrast the two-level microcode system of the invention might, for example, specify, with a vertical microinstruction, a horizontal instruction which requires the movement of data from an unspecified location to an unspecified location. Such microinstructions would be common to a large number of data movement instructions. The vertical microinstruction could then also contain in its modifier fields the specific source and destination locations for such data movement and thereby modify the basic horizontal microinstruction so as to identify such locations therein.

Further, the two-level microcode system of the invention can be arranged so that the vertical microinstructions can be fetched from control stores which are located directly on the microprocessor chip or, alternatively, from external microcontrol sources. The horizontal microcontrol store can also be located directly on the microprocessor chip.

The power of each horizontal microinstruction is effectively multiplied by the modifications of such microinstructions which can be achieved by the vertical microinstructions, such technique being sometimes designated herein as a two-level "micromodification" technique. Since each horizontal microinstruction can be modified by a large number of vertical microinstructions to represent thereby a large number of overall unique microinstructions, a relatively small number of horizontal microinstructions can be used to provide a general, but efficient set of basic control operations, sometimes referred to as "control primitives".

Description of the invention

The various aspects of the invention can be described more fully with the help of the accompanying drawings, wherein:

Fig. 1 shows a broad block diagram of an overall system in accordance with the invention;

Fig. 2 shows a block diagram of an exemplary central processor unit (CPU) of the system of Fig 1;

Fig. 3 shows a more specific diagram of the vertical sequence unit of the CPU of Fig. 2; and

Fig. 4 shows a more specific block diagram of the micro-modification unit of the CPU of Fig. 2.

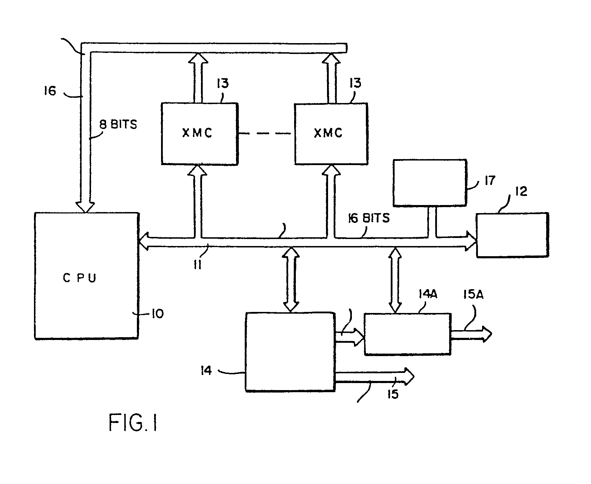

An overall system using the techniques of the invention is shown in Fig. 1 wherein a microprocessor chip 10 (identified as a central processor unit or CPU in the figure) is interconnected via an appropriate system bus 11 with a memory system 12, one or more system I/O units 17, one or more external microcontroller chips 13 (identified as "XMC" chips) and a system input/output interface unit 14 (identified as the system I/O interface) and a further interface unit 14A (identified as Eclipse® I/O interface) which latter units interface with appropriate buses 15 and 15A for external input/output devices. For example, in a particular embodiment the system is designed to operate with peripheral (I/O) units of the microNova type as used with microNova® computer systems as made and sold by Data General Corporation of Westboro, Massachusetts and with peripheral (I/O) units of the Eclipse® type as used with Eclipse® computer systems made by Data General Corporation.

In a particular embodiment thereof the system bus 11 is a 16-bit parallel system bus, as shown, while microcode bits from the external microcontroller chips 13 are transmitted to the CPU in a time-multiplexed fashion via a suitable dedicated eight-bit microcode bus 16.

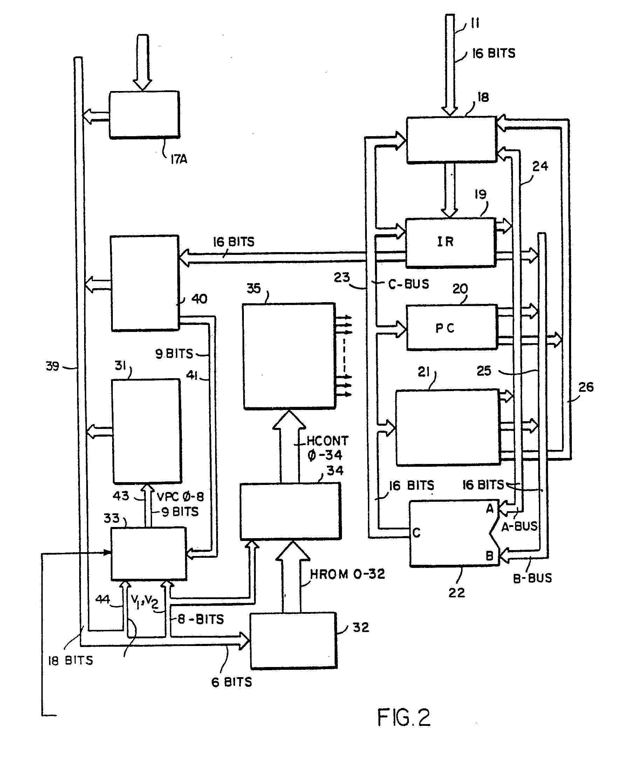

Fig. 2 depicts a more detailed block diagram of CPU 10, the eight-bit external microcode bus 16 supplying its microcode bits to an appropriate external microcontroller chip (XMC) interface unit 17A and the system bus 11 being connected to a suitable bus transceiver unit 18 capable of accepting or of supplying appropriate data for transmission to and from the CPU.

The CPU utilizes macro-instruction logic which includes macro-instruction register (IR) 19 and program counter (PC) register 20, together with a suitable register file 21, comprising appropriate general registers and accumulators, and a suitable arithmetic logic unit (ALU) and shifter unit 22 having "A" and "B" inputs and a "C" output, such registers, accumulators, ALU and shifter components being capable of implementation using suitable configurations well known to the art.

A plurality of four internal buses 23, 24, 25 and 26 provides for appropriate internal data paths among such units, as shown in Fig. 2. The C-output of the ALU and shifter logic 22 is supplied to the other units as well as to the system bus via bus transceiver on internal C-bus 23. The A and B inputs to the ALU and shifter logic 22 communicate with the other units via internal A-bus 24 and B-bus 25, respectively. Internal bus 26 provides a direct path from the registers and accumulators to the system bus 11 via bus transceiver 18. The use of such multiple internal data paths permits several concurrent operations to occur within a single microcycle, which in the particular embodiment discussed here is 400 nanoseconds. In accordance therewith, 16-bit register-to-register operations are performed in one microcycle (sometimes referred to as a T-period) and memory-to-register transfers are performed in two microcycles (two T-periods).

The two-level microcontrol stores are depicted as vertical control read-only memory (ROM) 31 and horizontal control ROM 32. In a particular embodiment of the invention, the first level, or vertical, control ROM 31, provides an 18-bit vertical microinstruction, 6 of such bits being used to select one of a plurality of second level, or horizontal, microinstructions at horizontal microcontrol ROM 32, there being 64 of such instructions stored therein in the particular embodiment shown here. Horizontal control ROM 32 provides horizontal microinstructions having 33 bits, in a particular embodiment, the horizontal control ROM, for example, having a 64×33 bit configuration. In the embodiment described, eight bits from the vertical control store 31 are used to provide two 4-bit modifier fields which can be used to modify the horizontal microinstruction which has been selected from the horizontal microcontrol ROM as discussed below. The remaining four bits of each vertical microinstruction are used to control the sequencing of the vertical microinstructions, i.e., to specify the next address mode from vertical control ROM 31 via appropriate vertical sequencing logic 33. The modification of specified fields of the selected horizontal microinstruction by the two-modifier fields of the vertical microinstruction is accomplished via appropriate micro-modification logic 34 which thereupon supplies a 35-bit microinstruction word which is suitably decoded by horizontal decode logic 35 to provide the necessary control signals and sequencing signals required for performing the function of the selected microinstruction.

Vertical microinstructions can be fetched either from the CPU-resident vertical control ROM 31 or from an external microcontroller chip 13 (see Fig. 1) via external microcontroller chip interface unit 17A, while horizontal microinstructions are fetched from the CPU-resident horizontal control ROM 32. External microcode can be obtained from an XMC unit 13 by the use of suitable time-multiplexing techniques, the external vertical microcode comprising 16 bits supplied in time-multiplex 8-bit microcode bus 16.

The sequence of microinstructions required to be decoded by horizontal decode logic unit 35 is begun by a suitable decoding of a macroinstruction from instruction register 19 by a decoder control programmed logic array (PLA) unit 40. Decoding of such macroinstruction by the decode control PLA unit 40 provides an initial vertical microinstruction on internal bus 39, as well as supplying on internal bus 41 the address of the next microinstruction which is to be fetched from the vertical control ROM 31. The sequencing of vertical control ROM 31 is appropriately controlled by the 9-bit sequence control signal suppled from vertical sequencer logic 33 via internal bus 43. Once the decode control PLA unit 40 suppies the initial microinstruction and the address for the next microinstruction from vertical control ROM 31, the sequencing of subsequent vertical microinstructions from ROM 31 is determined by the sequencing bits supplied to vertical sequencer unit 33 at internal 4-bit bus 44. If the microinstruction from vertical control ROM 31 requires a branch, or jump, to another vertical microinstruction rather than the selection of a horizontal microinstruction, the modifier bits are used to specify the branching operation and the 6-bits normally used to select a horizontal microinstruction comprise a "no-operation" (NOOP) code which inhibits the micromodification unit 34 from using the 8-bit modifier fields for modification of a horizontal microinstruction.

Thus, in the micro-modification process, two 4-bit fields, for example, of the vertical microinstruction can be substituted for two or more 4-bit fields of the selected horizontal microinstruction. The technique of substituting vertical modifier fields into selected horizontal fields effectively multiples the power of each horizontal microinstruction so that the overall orthogonal, two-level microcontrol store approach described provides a general, yet bit-efficient, set of basic horizontal microinstruction operations, sometimes referred to as control primitives having powerful capabilities for expanding the number of microinstructions in the microinstruction set of the overall system.

It is helpful in understanding the micro-modification process to consider a complete horizontal microinstruction set stored in horizontal control ROM 32 as set forth in Appendix A.

In a particular embodiment, for example, the horizontal microinstructions each include the following nine fields as shown below:

| 4 | 4 | 4 | 4 | 4 | 3 | 2 | 4 | 4 |
|---|---|---|---|---|---|---|---|---|
| A-BUS | B-BUS | ALU | SHF | DEST | ADR | MEM | TEST | RAND |

The A-BUS field defines the source of the data for the A-input of ALU/shifter 22 on A-bus 24 while the B-bus field defines the source of data for the B-input of the ALU/shifter 22 on B-BUS 25. The ALU field defines the operational function to be performed by the ALU while the SHF field defines the shifter function. The DEST field defines the destination for the data which is placed on C-BUS 23 from the ALU/shifter 21. The ADR field defines the source of the memory address while the MEM field provides control for the interconnection between the system bus 11 and the C-BUS 23. The TEST field is used to identify various system conditions to be tested, while the RAND (random) field provides for other special control functions. Appendix A sets forth in more detail the meanings of each of the above fields.

The vertical microcontrol ROM 31 is a ROM configuration which in a particular embodiment, for example, includes 288 microinstruction words, each 18 bit wide, one horizontal microinstruction being executed for each vertical microinstruction that is executed. Sequences of vertical microinstructions interpret macro-instructions (i.e. machine instructions as decoded by decode control PLA unit 40).

The vertical microinstructions each involve the following four fields as shown below:

| 6 | 4 | 4 | 4 |
|---|---|---|---|
| ADRH | V1 | V2 | NAM |

The 6-bit ADRH field defines the address of the horizontal microinstruction which is to be selected in the horizontal main control store 32. The 4-bit V1 field defines the first modifier (sometimes referred to as modifier 1) for the selected horizontal microinstruction while the 4-bit V2 field (modifier 2) defines the second modifier for the selected horizontal microinstruction. A 4-bit NAM field which is supplied to the vertical sequencer logic 33 identifies the next address mode for selecting the next sequential vertical microinstruction, such mode bits being used to generate a new vertical program counter 9-bit address. Appendix B sets forth in more detail the meaning of each of the above fields.

As can be seen in Appendix A, in many of the horizontal microinstructions certain fields are specified as requiring one of the vertical microinstruction modifier fields, identified as either the V1 vertical modifier field or the V2 vertical modifier field. The remaining fields of each of the horizontal microinstructions are fixedly specified as shown. In a particular horizontal microinstruction, for example, identified as a "write memory" (WMEM) microinstruction, all fields thereof are specified except the ABUS field, which requires the use of the V1 vertical modifier field, and the ADR field, which requires the use of the V2 vertical modifier field, the V1 and V2 modifier fields being capable of identifying one of a plurality of sources of the data to be written (V1) and more or more addresses at which said sourced data is to be written (V2). Thus the basic and general write memory (WM) microinstruction can, with modification by the modifier fields, be used to generate a large number of specific "write" microinstructions with regard to a large combination of data sources and address destinations. In the particular embodiment discussed the use of two modifier fields permits a large number of microinstructions to be generated from only 64 basic horizontal microinstructions.

The decode control PLA unit 40 has a configuration which contains microinstructions each having 24 bits. Such unit is addressed with a 16-bit address from the instruction register 19 and provides the initial vertical microinstruction decoded from the macro-instruction and a 9-bit pointer to the next vertical microinstruction in the vertical control ROM 31 when a sequence of more than one microinstruction is required, as well as a flag which may invoke a subsequent macro-instruction for decoding where only a single microinstruction is required, as discussed below. There are as many entries in the decode control PLA unit 40 as there are macro-instructions implemented by the system of the invention.

The five fields of a starting microinstruction of decode control PLA unit 40 are shown below:

| 6 | 4 | 4 | 9 | 1 |
|---|---|---|---|---|
| ADRH | V1 | V2 | ADRV | D |

The 6-bit ADRH field is the same as that described above with reference to the vertical microcontrol ROM 31, the 4-bit V1 field and the 4-bit V2 field also being the same as those described above with reference to the vertical microcontrol ROM. In addition, the decode control PLA unit supplies a nine-bit ADRV field which is the address in the vertical control ROM 31 of the second microinstruction of the microinstruction sequence required for the decoded macro-instruction. A single bit (the D field) indicates that the single microinstruction provided by the decode control PLA suffices to interpret the macro-instruction. In this case the ADRV field is ignored. A more detailed summary of the five fields of a starting microinstruction is set forth in Appendix C.

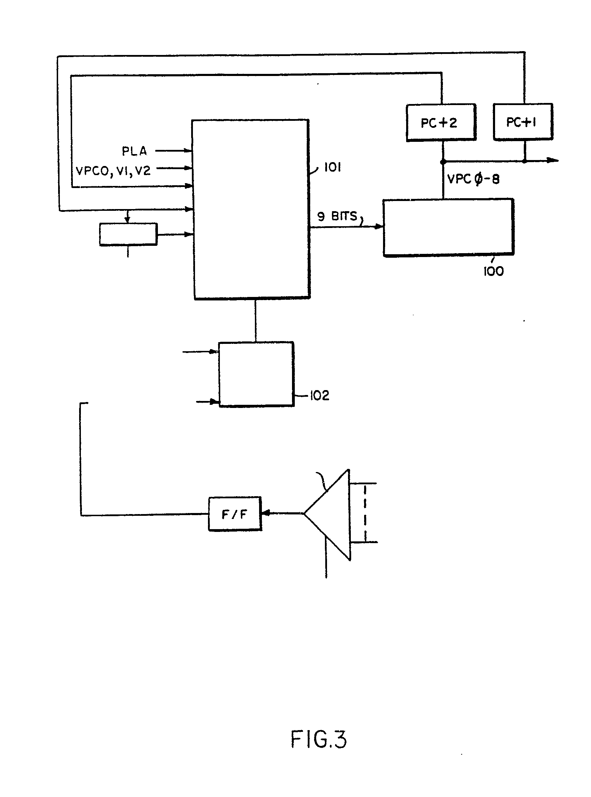

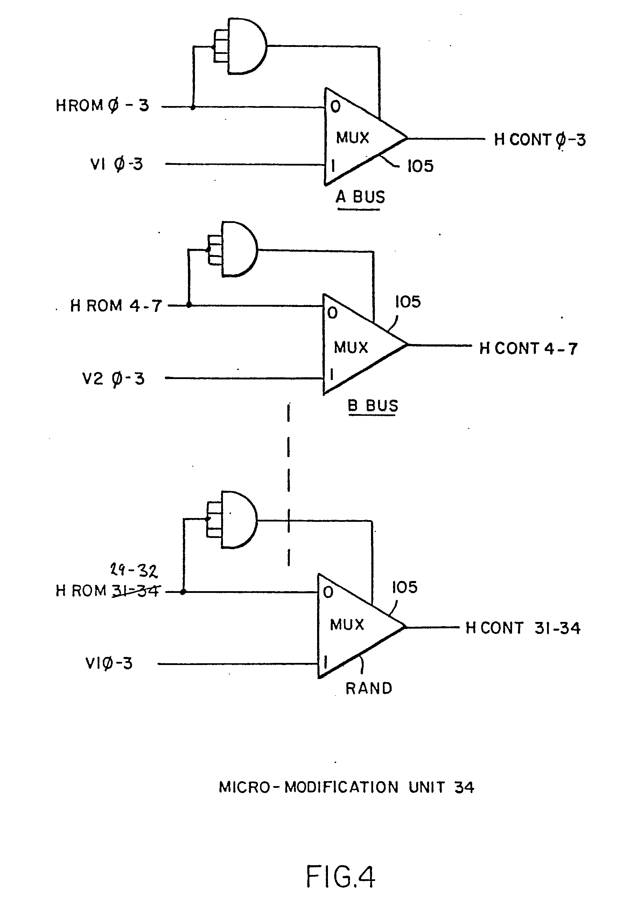

The vertical and horizontal control ROMs and the decode control PLA unit are conventional logic units well known to the art and need not be shown in greater detail. Logic for the vertical sequencer unit 33 and micromodification unit 34 are shown in Figs. 3 and 4, respectively.

As can be seen in Fig. 3, for example, the vertical sequencer in a particular embodiment can comprise a vertical program counter unit 100 and a multiplexer unit 101 which selects any one of five input signals to provide (1) for the decoding of the 9-bit output from decode control PLA unit 40, (2) for a jump (branch) or a call operation, identified by the zero-bit (VPC∅) of the program counter and the vertical modifier fields V1 and V2, (3) for a SKIP operation, i.e. a skip of the next program counter (PC+1) output to the next subsequent program counter output (PC+2), (4) the next program counter (PC+1) output, or a RETURN operation wherein the next program counter output (PC+1) is saved (as when an interrupt operation occurs) and then, following the interrupt routine, the vertical sequencer returns to the (PC+1) output.

The multiplexer operation is controlled by switching control logic 102 which provides for the next address mode of operation (wherein one of the above five operations is selected) when the test conditions required are present.

6

Fig. 4 shows the micromodification unit 34 which comprises a plurality of 2, or 3, input multiplexers 105 each of which includes either a 4-bit horizontal input (for horizontal fields ABU, BBUS, ALU, SHF, DEST, TEST and RAND), a 3-bit horizontal input (for horizontal ADR field) or a 2-bit horizontal input (for horizontal MEM field) and either a V1 input (horizontal fields ABUS, ALU, RAND), a V2 input (horizontal fields BBUS, SHF, ADR, MEM and TEST) or both V1 and V2 fields (horizontal DEST field), as shown in Appendix A. The 4-bit horizontal inputs (HROM inputs) control the selection of the multiplexer input as either from the HROM bits or the V1 or V2 bits for supply to the horizontal decode logic 35.

The above discussed embodiment utilizes the particular fields specified for the horizontal micro-instructions and set forth in Appendix D. In most cases, as can be seen, the horizontal fields which use the vertical modifier fields are those which specify source and destination locations. For example, for an INCH (increment) microinstruction, the A-BUS field is modified by the V1 vertical modifier field, the data at the location specified by V1 to be incremented being placed on the A-BUS, and the DEST field is modified by the V2 vertical modifier field, the incremented data then being placed in the location specified by V2.

The memory field (MEM) in the particular embodiment described bears special scrutiny. Up to 16 memory operations can be defined by using a 4-bit MEM field. However, as is noted in Appendix D only four operations are specified, i.e., NOOP (no operation), RM (read memory), WM (write memory), and a V2 field. In this case the V2 field must be used to specify memory operations other than RM and WM. Thus, as can be seen in specific horizontal microinstruction micro-order encodings of Appendix E, the V2 modifier can specify the other memory operations (i.e. WHM, RMOD, WLM, RHYP, etc). Thus, the MEM field need only use 2 bits (rather than 4 bits) with a vertical modifier used to specify all operations other than an RM and a WM. Thus, the horizontal control ROM 32 needs to provide only 33 bits, as shown in Fig. 2. However, as seen in Appendix E, and as shown in Fig. 4, 35 bits can be supplied to the micro-modification unit 34, two of the MEM bits 23—26 having no operating significance.

In each case where the memory operation is defined by the V2 modifier, the V2 modifier cannot be used to specify any other field and only the V1 modifier is free to modify one or the other fields, as appropriate. However, for both RM and WM operations both V1 and V2 modifiers are so available. Since most memory operations are RM or WM operations (where both V1 and V2 modifications are available), the modifier limitation placed on the other (not RM or WM) memory operations is not severe inasmuch as such latter operations are not often used. However, the overall flexibility of the MEM field operations is considerably increased since only four microinstructions are needed to specify memory operation horizontals. The use of the V2 modifier field increases the range of micro-order (control states) for memory operations to 15 additional micro-orders, as shown in Appendix E.

A similar arrangement may be used for other horizontal microinstruction fields, if desired, and the overall horizontal control ROM can be used to specify relatively few microinstructions, the ranges of micro-orders thereof being considerably increased by defining additional control states by using a vertical modifier field. While the use of one of the two vertical modifiers for such purpose limits the ability to modify more than one other field, in many instances the need to modify more than one other field may not be critical. Obviously, if one increases the number of vertical modifier fields, flexibility increases in this regard at the cost of a larger vertical microinstruction word.

In the limit, it may be possible to use a single horizontal microinstruction with a single bit for each field thereof which bit in each case specifies whether a modifier is to be used for such field or whether a default operation is to occur. In such a system, the number of available vertical modifiers should be sufficient to permit modification of all fields which require it for each definable micro-order. The range of horizontal microinstruction micro-orders can thereby be considerably increased at the expense of the requirement for relatively large vertical microinstruction words having the desired number of modifier fields.

Appendix A
Horizontal microinstruction set
ABUS field (4 bits wide; 16 encodings)

| | V1 | vertical modifier 1 |
|---|---|---|
| | GI | GI |
| | GD | GD |
| | GR | GR |
| | GL | GL |
| | IRESX | IRE<8—15>, sign extended if IRE<6—7>. NE.O |
| | IRD | IRD |
| | ACSR | ACSR |
| | BIT | 2** (15—GR<12—15>) |
| | BONE | 377 (byte of 1s right justified) |
| | ZERO | 0 |

Notes on the use of ABUS micro-orders

(1) Any microinstruction which uses BIT must be preceded by at least one microinstruction which does not modify GR (it takes one I period for BIT to settle once GR is written)

(2) ACSR is loaded with IRD<1—2> when IRE is loaded with IRD. ACSR is loaded with CBUS<1—2> when IRE is loaded with CBUS.

BBUS field (4 bits wide, 16 encodings)

| | V2 | vertical modifier 2 |
|---|---|---|
| | GI | GI |
| | GD | GD |
| | GR | GR |
| | GL | GL |
| | PCE | PCE |
| | PCD | PCD |
| | LIT | V1 !!V2 right justified |
| | IRE IO | standard I/O instruction format based on IRE (see notes) |
| | XP12 | O (PCD, AC2, AC3) if IRE<1—2>=0 (1, 2, 3) |
| | XR67 | O (POx, AC2, AC3) if IRE<6—7>=0 (1, 2, 3) x=PCE if EFA, x=PCD if xEFA |
| | MONE | −1 |

Notes on the use of BBUS micro-orders

(1) IRE IO is used to trigger the actual I/O to devices CPU and MAP which are partially implemented on the CPU chip (RIO and WIO) normally trigger the I/O). Caution should be exercised when coding IRE IO to execute during a DECODE CYCLE

(2) IRE IO word format is as follows:
IRE 10<0>=0, IRE IO<1> is reserved
IRE IO<10—15> is the device code

8

# 0 035 334

| System function | Function | Direction | · Control · |
|---|---|---|---|
| IRE IO<2—4> | IRE IO<5—6> | IRE IO<7> | IRE IO<8—9> |
| 000 NO-OP | 00 STATUS | 0 OUT | 00 NO-OP |
| 001 INIA | 01 B REG | 1 IN | 01 START |
| 010 MSKO | 10 B REG | | 10 CLEAR |
| 011 IORST | 11 C REG | | 11 PULSE |
| 100 DCHA | | | |
| 101 DCHI | | | |
| 110 DCHO | | | |
| 111 Spare | | | |

DCHA, DCHI, and DCHO are not generated by the CPU chip but are used by the System I/O interface unit.

ALU field (4 bits wide, 16 encodings)

| V1 | vertical modifier 1 |
|---|---|
| COM | A' |
| NEG | −A |
| MOV | pass A |
| INC | A+1 |
| ADC | B−A−1 |
| SUB | B−A |
| ADD | A+B |
| AND | A^B |
| AD1 | A+B+1 |
| ANC | A'B |
| MUL | unsigned multiply iteration step |
| MULS | signed multiply iteration step |
| DIV | unsigned divide iteration step |

Notes on the use of ALU micro-orders
(1) A and B refer to the contents of ABUS and BBUS respectively
(2) ALC hardware can directly control ALU; ALU field mnemonics are consistent with ALC instructions

9

**0 035 334**

SHF field (4 bits wide, 16 encodings)

| | | |
|---|---|---|
| | V2 | vertical modifier 2 |
| | PASS | pass |
| | PASSO | pass, XBUS<0>=0 |
| | PASSC | pass, XBUS<0>=CARRY |
| | SHL | shift left, pull x into LSB (see note) |
| | LSHR | logical shift right, pull x into MSB (see note) |
| | ASHR | arithmetic shift right, do not change sign bit |
| | SHLC | shift left, pull CARRY into LSB |
| | SHRC | shift right, pull CARRY into MSB |
| | SWAP | swap bytes |
| | ROL | 16 bit rotate left |
| | ROR | 16 bit rotate right |
| | ROLC | 17 bit rotate left, CARRY participates |
| | RORC | 17 bit rotate right, CARRY participates |

Note on the use of SHF micro-orders
   For SHL and LSHR: x=0 unless ALU field is used to invoke multiply or divide

DEST field (4 bits wide, 16 encodings)

| | | |
|---|---|---|
| | V1 | vertical modifier 1 |
| | V2 | vertical modifier 2 |
| | GI | GI |
| | GD | GD |
| | GR | GR |
| | GL | GL |
| | PCF | PCF |
| | IRE | IRE |
| | NOLD | no load |

Note on the use of DEST micro-orders
   For IRE ACSR is also loaded with CBUS<1—2> unless CBUS is sourced by MBUS

**0 035 334**

ADR field (3 bits wide, 8 encodings)

| V2 | vertical modifier 2 |
|---|---|
| NONE | no address |
| SP | 40 (stack pointer) |
| FP | 41 (frame pointer) |
| SL | 42 (stack limit) |
| GI | GI |
| GD | GD |

Notes on the use of ADR micro-orders

(1) Memory address source drives MBUS during PHASE 1 only

(2) MBUS<0> is forced to 0 unless RHYP/WHYP is issued or RLCL/WLCL is issued or HYPMOD (hyperspace mode flag)=1

MEM field (2 bits wide, 4 encodings)

| V2 | vertical modifier 2 |
|---|---|
| NOP | no operation |
| RM | read memory |
| WM | write memory |

Notes on the use of MEM micro-orders

(1) Read operations cause CBUS to be sourced by MBUS (MBB) during PHASE 2 (read data)

(2) Write operations cause MBUS to be sourced by ABUS (MBP) during PHASE 2 (write data)

(3) CBUS is sourced by xBUS whenever a read operation is not taking place (xIO)

Test field (4 bits wide, 16 encodings)

| V2 | vertical modifier 2 |
|---|---|
| NOP | SKIP=SKIP |
| SET | SKIP=1 |
| CLEAR | SKIP=0 |
| GEQZ | SKIP=1 if GI increments to zero (GIINC or GIAINC) or GD decrements to zero (GDDEC or GDADEC), else SKIP=0 |
| INTP | SKIP=1 if PI is pending, else SKIP=0 |
| ACSRQ | SKIP=1 if ACSR=IRE<3—4>, else SKIP=0 |
| UCRYB | SKIP=0 if carry out of ALU<0>=1, else SKIP=1 |
| SCRYB | SKIP=0 if signed carry out of ALU<0>=1, else SKIP=1 (see note) |
| DCRY | SKIP=1 if decimal overflow or decimal borrow occurs, else SKIP=0 (see note) |
| SHOUT | SKIP=1 if SHIFTER rotates or shifts out a 1, else SKIP=0 |
| XEQZ | SKIP=1 if XBUS<0—15>=0, else SKIP=0 |
| XNEG | SKIP=1 if XBUS<0>=1, else SKIP=0 |
| IOSKP | SKIP=1 if the I/O SKIP condition being tested is true, else SKIP=0 |
| NMIP | SKIP=1 if NM1 is pending, else SKIP=0 |
| OVFLO | SKIP=1 if carry out of ALU<0> and carry into ALU<0> do not match, else SKIP=0 |

11

Notes on the use of TEST micro-orders

(1) ACSR is loaded with IRD<1—2> when IRE is loaded with IRD. ACSR is loaded with CBUS<1—2> when IRE is loaded with CBUS

(2) SCRYB=(ALU<∅> .XOR. OVFLO)

(3) DCRY=(carry out of ALU<12> .XOR. SUB) .OR. ((ALU<12—15>9.) .AND. ADD)

(4) UCRYB may be used for unsigned integer comparisons and SCRYB may be used for signed integer comparisons

(5) The increment/decrement happens first if ACSR is incremented/decremented and ACSRQ is issued. Likewise for the increment/decrement using GEQZ

(6) for IOSKP, the truth of the I/O skip condition is determined by the contents of the ABUS (DIS word) and IRE<8—9>. The DIS word format is as follows:

DIS<0>=DONE (POWER FAIL if DIS 77)

DIS<1>=BUSY (ION if DIS 77)

DIS<2—14>are reserved

DIS<15>=NMI caused by HALT if DIS 77 else reserved

RAND field (4 bits wide, 16 encodings)

| | V1 | vertical modifier 1 |
|---|---|---|
| | NOP | no operation |
| | IR5TOI | I (indirect enable)=IRE<5> |
| | AOTOI | I (indirect enable)=ABUS<0> |
| | GIINC | increment GI |
| | GDDEC | decrement GD |
| | GIAINC | increment GI and ACSR |
| | GDADEC | decrement GD and ACSR |
| | SETCRY | CARRY=1 |
| | CLRCRY | CARRY=0 |
| | GLL | shift GL left, pull x into LSB (see note) |
| | GRR | shift GR right, pull x into MSB (see note) |
| | GLLGDD | decrement GD, shift GL left and pull x into LSB (see note) |
| | GRRGDD | decrement GD, shift GR right and pull x into MSB (see note) |
| | HYPON | HYPMOD (hyperspace mode flag)=1 |

Note on the use of RAND micro-orders

For GLL, GRR, GLLGDD, and GRRGDD: if multiply or divide is not invoked using the ALU field, then x equals the bit rotated or shifted out of the SHIFTER (x=0 if SHIFTER is not rotating or shifting), else MUL/DIV logic determines x

Appendix B

Vertical microinstruction set

ADRH field (6 bits wide, 64 encodings)

Each encoding selects one of 64 horizontal microinstructions in the HPLA. The selected horizontal is executed. If the executed horizontal sets I (indirect enable) (a horizontal which sets I is called an "indirect initiator"), then field V2 is saved in the 4 bit wide instruction class register (ICR) and used to control indirect address chains and the MAP. The ICR is interpreted as follows:

12

ICR<0> (1000) Jump-type instruction, PCF is loaded whenever GI is loaded

ICR<1> (0100) reserved

ICR<2—3> (0001) MAP indirect cycle turn-on
 (0011) MAP single cycle turn-on and/or indirect cycle turn-on

The ICR is cleared by every DECODE CYCLE whose vertical does not specify a horizontal that is an indirect initiator.

V1 field/ABUS modification (4 bits wide, 16 encodings)

| | |
|---|---|
| AC0 | AC0 |
| AC1 | AC1 |
| AC2 | AC2 |
| AC3 | AC3 |
| ACS | ACx, x=ACSR |
| ACD | ACx, x=IRE<3—4> |
| GI | see horizontal |
| GD | see horizontal |
| GR | see horizontal |
| GL | see horizontal |
| IRESx | see horizontal |
| IRD | see horizontal |
| ACSR | see horizontal |
| BIT | see horizontal |
| BONE | see horizontal |
| ZERO | see horizontal |

Note on the use of ABUS modifiers
ACSR is loaded with IRD<1—2> when IRE is loaded with IRD.
ACSR is loaded with CBUS<1—2> when IRE is loaded with CBUS.

**0 035 334**

V2 field/BBUS modification (4 bits wide, 16 encodings)

| | |
|---|---|
| AC0 | AC0 |
| AC1 | AC1 |
| AC2 | AC2 |
| AC3 | AC3 |
| ACS | ACx, x=ACSR |
| ACD | ACx, x=IRE<3—4> |
| GI | see horizontal |
| GD | see horizontal |
| GR | see horizontal |
| GL | see horizontal |
| PCE | see horizontal |
| PCD | see horizontal |
| LIT | see horizontal |
| IRE IO | see horizontal |
| MONE | see horizontal |

Note on the use of BBUS modifiers
ACSR is loaded with IRD<1—2> when IRE is loaded with IRD.
ACSR is loaded with CBUS<1—2> when IRE is loaded with CBUS.

V1 field/ALU modification (4 bits wide, 16 encodings)

| | |
|---|---|
| COM | see horizontal |
| NEG | see horizontal |
| MOV | see horizontal |
| INC | see horizontal |
| ADC | see horizontal |
| SUB | see horizontal |
| ADD | see horizontal |
| AND | see horizontal |
| AD1 | see horizontal |
| ANC | see horizontal |

14

V2 field/SHF modification (4 bits wide, 16 encodings)

| | |
|---|---|
| PASS | see horizontal |
| PASSO | see horizontal |
| PASSC | see horizontal |
| SHL | see horizontal |
| LSHR | see horizontal |
| ASHR | see horizontal |
| SHLC | see horizontal |
| SHRC | see horizontal |
| SWAP | see horizontal |
| ROL | see horizontal |
| ROR | see horizontal |
| ROLC | see horizontal |
| RORC | see horizontal |

V1 and V2 fields/DEST modification (4 bits wide, 16 encodings)

| | |
|---|---|
| AC0 | AC0 |
| AC1 | AC1 |
| AC2 | AC2 |
| AC3 | AC3 |
| ACS | ACx, x=ACSR |
| ACD | ACx, x=IRE<3—4> |
| GI | see horizontal |
| GD | see horizontal |
| GR | see horizontal |
| GL | see horizontal |
| PCF | see horizontal |
| IRE | see horizontal |
| NOLD | see horizontal |

Note on the use of DEST modifiers

ACSR is loaded with IRD<1—2> when IRE is loaded with IRD.

ACSR is loaded with CBUS<1—2> when IRE is loaded with CBUS

V2 field/ADR modification (4 bits wide, 8 encodings)

| | |
|---|---|
| NONE | see horizontal |
| SP | see horizontal |
| FP | see horizontal |
| SL | see horizontal |
| GI | see horizontal |
| GD | see horizontal |

Notes on the use of ADR modifiers

(1) There are only 8 encodings since horizontal's ADR field is only 3 bits wide

(2) Memory address formats are as follows:

USER SPACE, MEMCYC=1
address<0>=0
address<1—15>=register select

HYPERSPACE, MEMCYC=1
address<0>=1
address<1—15>=register select

I/O SPACE, MEMCYC=0
same as IREIO word format

LOCAL SPACE, MEMCYC=0
address<0>=1
address<1—5>=sub-register select
address<6—9>=register select
address<10—15>=device select

V2 field/MEM modification (4 bits wide, 16 encodings)

| | |
|---|---|
| NOP | see horizontal |
| RM | see horizontal |
| WM | see horizontal |
| RMOD | read and lock memory |
| WHM | write memory, high byte only |
| WLM | write memory, low byte only |
| RHYP | read hyperspace |
| WHYP | write hyperspace |
| RIO | read I/O |
| WIO | write I/O |
| RLCL | read local |
| WLCL | write local |
| XCT | take data on memory bus into IRF, assert FETCH |
| MAPON | turn MAP on if armed |
| MAPOFF | turn MAP off |

16

**0 035 334**

Notes on the use of MEM modifiers

(1) For RMOD, memory is un-locked by the next memory operation if it is not another RMOD

(2) For XCT, microcode should force a memory cycle to fake out IR PIPES) using a WLCL to device 0 register 0

(3) MAPOFF will inhibit I/O interrupts until after the next macroinstruction has begun execution. This feature does not work if MAPOFF is coded to execute during a DECODE CYCLE

V2 field/TEST modification (4 bits wide, 16 encodings)

| | |
|---|---|
| NOP | see horizontal |
| SET | see horizontal |
| CLEAR | see horizontal |
| GEQZ | see horizontal |
| INTP | see horizontal |
| ACSRQ | see horizontal |
| UCRYB | see horizontal |
| SCRYB | see horizontal |
| DCRY | see horizontal |
| SHOUT | see horizontal |
| XEQZ | see horizontal |
| XNEG | see horizontal |
| IOSKP | see horizontal |
| NMIP | see horizontal |
| OVFLO | see horizontal |

V1 field/RAND modification (4 bits wide, 16 encodings)

| | |
|---|---|
| NOP | see horizontal |
| IR5TOI | see horizontal |
| AOTOI | see horizontal |
| GIINC | see horizontal |
| GDDEC | see horizontal |
| GIAINC | see horizontal |
| GDADEC | see horizontal |
| SETCRY | see horizontal |
| CLRCRY | see horizontal |
| GLL | see horizontal |
| GRR | see horizontal |
| GLLGDD | see horizontal |
| GRRGDD | see horizontal |
| HYPON | see horizontal |

17

NAM field (4 bits wide, 16 encodings)

| | |
|---|---|
| NEXT | VPC=VPC+1 |
| SKIP | VPC=VPC+1+1 |
| JUMP | unconditional transfer (VPC=V1!!V2) |
| DECODE | begin interpretation of a new macroinstruction |
| SDCODE | DECODE but allow a macro skip |
| TJUMP | if SKIP=1 then JUMP, else NEXT |
| FJUMP | if SKIP=0 then JUMP, else NEXT |
| TSKIP | if SKIP=1 then SKIP, else NEXT |
| FSKIP | if SKIP=0 then SKIP, else NEXT |
| TREPT | if SKIP=1 then JUMP to current VPC, else NEXT |
| FREPT | if SKIP=0 then JUMP to current VPC, else NEXT |
| TDCODE | if SKIP=1 then DECODE, else NEXT |
| FDCODE | if SKIP=0 then DECODE, else NEXT |
| CALL | subroutine call (VPCSAV=VPC+1, VPC=V1!!V2) |
| RTRN | subroutine return (VPC=VPCSAV) |

Notes on the use of NAM micro-orders

(1) The NAM field senses the old value of the SKIP flag, not the new value which is determined by the horizontal selected by the currently executing vertical

(2) Special hardware conditions such as NMI (Non Maskable Interrupt) are handled during a DECODE CYCLE

(3) If SKIP=1 and an SDCODE is issued, then the macro-instruction in IRD is not executed. The next macro-instruction to be executed is found in IRF (the macro-instruction in IRD is skipped). This is called "macro skip" and is used by macroinstruction interpreters such as CLM

(4) It is illegal to write PCF or read IRD if a DECODE is issued (i.e. you can't start the autonomous fetch unit and DECODE simultaneously)

(5) VPC sequencing is polynomial, not binary

(6) SKIP is cleared by every DECODE CYCLE

Appendix C

Starting microinstruction set

ADRH, V1 and V2 fields (total 14 bits wide)

Same as in vertical control ROM (VCR)

ADRV field (9 bits wide, 512 encodings)

Each encoding is a pointer to one of 286 vertical microinstructions in the VCR. This pointer is loaded into the VERTICAL PC (VPC) to begin normal vertical sequencing through the VCR

D field (1 bit wide, 2 encodings)

N do not invoke a macroinstruction decode

Y invoke a macroinstruction decode and allow a macro skip

Notes

(1) The D field is used by macroinstruction interpreters which consists of only one vertical microinstruction (e.g. ALCs). In those cases, the VCR is not accessed

(2) The ADRV field is ignored if a macroinstruction decode is invoked using the D field

(3) If SKIP=1 and a macroinstruction decode is invoked using the D field, then the macroinstruction in IRD is not executed. The next macroinstruction to be executed is found in IRF (the macroinstruction in IRD is skipped). This is called "macro-skip" and is used by the ALCs and others

(4) It is illegal to write PCF or read IRD if a macroinstruction decode is invoked (i.e. you can't start the autonomous fetch unit and decode simultaneously)

(5) SKIP is cleared by every DECODE CYCLE

## 0 035 334

Appendix D

| | LABEL | ABUS | BBUS | ALU | SHF | DEST | ADR | MEM | TEST | BAND |
|---|---|---|---|---|---|---|---|---|---|---|
| 0000 | NOOP: | — | — | — | PASS | NOLD | NONE | NOP | NOP | NOP |
| 0001 | RMEM: | V1 | — | — | PASS | V1 | V2 | RM | MOP | NOP |
| 0002 | WMEM: | V1 | — | — | PASS | NOLD | V2 | WM | NOP | NOP |
| 0003 | XMEMGI: | V1 | — | MOV | PASS | V1 | GIADR | V2 | NOP | NOP |
| 0004 | XMEMGD: | V1 | — | MOV | PASS | V1 | GDADR | V2 | NOP | NOP |
| 0005 | XMEMIG: | V1 | — | MOV | PASS | V1 | GIADR | V2 | NOP | GIINC |
| 0006 | XMEMDG: | V1 | — | MOV | PASS | V1 | GDADR | V2 | NOP | GDDEC |
| 0007 | COMH: | V1 | — | COM | PASS | V2 | NONE | NOP | NOP | NOP |
| 0010 | NEGH: | V1 | — | NEG | PASS | V2 | NONE | NOP | NOP | NOP |
| 0011 | MOVH: | V1 | — | MOV | PASS | V2 | NONE | NOP | NOP | NOP |
| 0012 | INCH: | V1 | — | INC | PASS | V2 | NONE | NOP | NOP | NOP |
| 0013 | ADCH: | V1 | V2 | ADC | PASS | V2 | NONE | NOP | NOP | NOP |
| 0014 | SUBH: | V1 | V2 | SUB | PASS | V2 | NONE | NOP | NOP | NOP |
| 0015 | ADDH: | V1 | V2 | ADD | PASS | V2 | NONE | NOP | NOP | NOP |
| 0016 | ANDH: | V1 | V2 | AND | PASS | V2 | NONE | NOP | NOP | NOP |
| 0017 | AD1H: | V1 | V2 | AD1 | PASS | V2 | NONE | NOP | NOP | NOP |
| 0020 | ANCH: | V1 | V2 | ANC | PASS | V2 | NONE | NOP | NOP | NOP |
| 0021 | DECH: | V1 | MONE | ADD | PASS | V2 | NONE | NOP | NOP | NOP |
| 0022 | MOVIT: | V1 | — | MOV | PASS | GI | NONE | NOP | V2 | NOP |
| 0023 | ADDHC: | V1 | V2 | ADD | PASS | V2 | NONE | NOP | UCRYB | NOP |
| 0024 | GIDAS: | GD | GI | V1 | V2 | GD | NONE | NOP | NOP | NOP |
| 0025 | GIDAT: | GD | GI | V1 | PASS | GD | NONE | NOP | V2 | NOP |
| 0026 | GRLAS: | GL | GR | V1 | V2 | GL | NONE | NOP | NOP | NOP |
| 0027 | GRLAT: | GL | GR | V1 | PASS | GL | NONE | NOP | V2 | NOP |
| 0030 | MULH: | V1 | V2 | MUL | LSHR | V2 | NONE | NOP | GEQZ | GRRGDD |
| 0031 | MULSH: | V1 | V2 | MULS | LSHR | V2 | NONE | NOP | GEQZ | GRRGDD |
| 0032 | DIVH: | V1 | V2 | DIV | ROLC | V2 | NONE | NOP | GEQZ | GLLGDD |
| 0033 | SHIFT: | V1 | — | MOV | V2 | V1 | NONE | NOP | NOP | NOP |
| 0034 | SHIFTO: | V1 | — | MOV | V2 | V1 | NONE | NOP | SHOUT | NOP |
| 0035 | SHIFTN: | V1 | — | MOV | V2 | V1 | NONE | NOP | XNEG | NOP |
| 0036 | TST: | V1 | — | MOV | PASS | NOLD | NONE | NOP | V2 | NOP |
| 0037 | RANTST: | GI | — | MOV | PASS | NOLD | NONE | NOP | V2 | V1 |

19

Appendix D (Continued)

| 0040 | LITGI: | ZERO | LIT | ADD | PASS | GI | NONE | NOP | NOP | NOP |
|---|---|---|---|---|---|---|---|---|---|---|
| 0041 | LITGD: | ZERO | LIT | ADD | PASS | GD | NONE | NOP | NOP | NOP |
| 0042 | LITGR: | ZERO | LIT | ADD | PASS | GR | NONE | NOP | NOP | NOP |
| 0043 | LITGl: | ZERO | LIT | ADD | PASS | GL | NONE | NOP | NOP | NOP |
| 0044 | LITSGI: | ZERO | LIT | ADD | SWAP | GI | NONE | NOP | NOP | NOP |
| 0045 | ADDLIT: | GI | LIT | ADD | PASS | GI | NONE | NOP | NOP | NOP |
| 0046 | MOVHRQ: | ZERO | V2 | ADD | PASSO | V1 | NONE | NOP | NOP | NOP |
| 0047 | INCHRO: | ZERO | V2 | AD1 | PASSO | V1 | NONE | NOP | NOP | NOP |
| 0050 | DCMPGT: | V1 | V2 | SUB | PASS | NOLD | NONE | NOP | UCRYB | NOP |
| 0051 | UCMPGE: | V1 | V2 | ADC | PASS | NOLD | NONE | NOP | UCRYB | NOP |
| 0052 | SCMPGT: | V1 | V2 | SUB | PASS | NOLD | NONE | NOP | SCRYB | NOP |
| 0053 | SCMPGE: | V1 | V2 | ADC | PASS | NOLD | NONE | NOP | SCRYB | NOP |
| 0054 | COMPEQ: | V1 | V2 | SUB | PASS | NOLD | NONE | NOP | XEQZ | NOP |
| 0055 | SDSHL: | V1 | — | MOV | SHL | V1 | NONE | NOP | V2 | GLLGDD |
| 0056 | SDSHR: | V1 | — | MOV | LSHR | V1 | NONE | NOP | V2 | GRRGDD |
| 0057 | EFA: | IRESX | XR67 | ADD | PASS | GI | NONE | NOP | CLEAR | IR5TOI |
| 0060 | XEFA12: | IRD | XR12 | ADD | PASS | GI | NONE | NOP | CLEAR | AOTOI |
| 0061 | XEFA67: | IRD | XR67 | ADD | PASS | GI | NONE | NOP | CLEAR | AOTOI |
| 0062 | MOVIII: | V1 | — | MOV | PASS | GI | NONE | NOP | CLEAR | AOTOI |
| 0063 | RMEMI: | V1 | — | — | PASS | V1 | GIADR | RM | V2 | GIINC |
| 0064 | RMEMD: | — | — | — | PASS | V1 | GDADR | RM | V2 | GDADEC |
| 0065 | WMEMI: | V1 | — | — | PASS | NOLD | GIADR | WM | V2 | GIAINC |
| 0066 | WMEMD: | V1 | — | — | PASS | NOLD | CDADR | WM | V2 | GDDEC |
| 0067 | INCT: | V1 | — | INC | PASS | V1 | NONE | NOP | V2 | NOP |
| 0070 | DECT: | V1 | MONE | ADD | PASS | V1 | NONE | NOP | V2 | NOP |
| 0071 | NEGT: | V1 | — | NEG | PASS | V1 | NONE | NOP | V2 | NOP |
| 0072 | HIBYTE: | BONE | V2 | ANC | SWAP | V1 | NONE | NOP | NOP | NOP |
| 0073 | LOBYTE: | BONE | V2 | AND | PASS | V1 | NONE | NOP | NOP | NOP |
| 0074 | MASRTZ: | V1 | V2 | AND | PASS | NOLD | NONE | NOP | XEQZ | NOP |
| 0075 | SHOGI: | V1 | — | MOV | V2 | GI | NONE | NOP | SHOUT | NOP |
| 0076 | SHOGD: | V1 | — | MOV | V2 | GD | NONE | NOP | SHOUT | NOP |

.LOC 77; IND is locked to the indirect address chaining mechanism

| 0077 | IND: | — | — | — | PASS | GI | GIADR | RM | NOP | |

20

**0 035 334**

Appendix E
Horizontal microinstruction micro-order encodings

| | 0 3 | 4 7 | 8 11 | 12 15 | 16 19 | 20 22 | 23 26 | 27 30 | 31 34 |
|------|------|------|------|------|------|------|------|------|------|
| HCR* | ABUS | BBUS | ALU | SHF | DEST | ADR | MEM | TEST | RAND |
| 0000 | AC0 | AC0 | COM | PASS | V1 | NONE | NOP | NOP | NOP |
| 0001 | AC1 | AC1 | NEG | ASHR | V1 | SP | WM | V2 | V1 |
| 0010 | AC2 | AC2 | MOV | PASSO | V2 | GDADR | RM | ACSRQ | AOTO1 |
| 0011 | AC3 | AC3 | INC | PASSC | V2 | SL | V2 | GEQZ | NOP |
| 0100 | GI | GI | ADC | SRL | GI | GIADR | | XEQZ | GLL |
| 0101 | GD | GD | SUB | ROL | GD | FP | | SHOUT | GLLGDD |
| 0110 | GR | GR | ADD | SHLC | GR | V2 | | IMTP | GLRCRY |
| 0111 | GL | GL | AD1 | ROLC | GL | V2 | | NMTP | GDDEC |
| 1000 | ZERO | MONE | MUL | LSHR | NOLD | | | XNEG | GIINC |
| 1001 | ZERO | XR67 | MULS | ROR | NOLD | | | IOSKP | GIAINC |
| 1010 | BONE | PCE | DIV | SHRC | PCF | | | DCRY | IR5TOI |
| 1011 | IRD | PCD | AD1 | RORC | PCF | | | SCRYB | HYPON |
| 1100 | IRESX | IREIO | ANC | SWAP | IRE | | | UCRYB | GRR |
| 1101 | BIT | LIT | ANC | SWAP | IRE | | | CLEAR | GRRGDD |
| 1110 | ACSR | xR12 | AND | V2 | NOLD | | | OVFLO | SETCRY |
| 1111 | V1 | V2 | V1 | V2 | NOLD | | | SET | GDADEC |

*Horizontal Control ROM

21

Appendix E (Continued)

| MODIFIER | V1 | V2 | V1 | V2 | V1&V2 | V2 | V2 | V2 | V1 |
|---|---|---|---|---|---|---|---|---|---|
| 0000 | AC0 | AC0 | COM | PASS | AC0 | NONE | NOP | NOP | NOP |
| 0001 | AC1 | AC1 | NEG | ASHR | AC1 | SP | WM | NOP | V1 |
| 0010 | AC2 | AC2 | MOV | PASSO | AC2 | GDADR | RM | ACSHQ | AOTO1 |
| 0011 | AC3 | AC3 | INC | PASSC | AC3 | SL | WHM | GEQZ | NOP |
| 0100 | GI | GI | ADC | SRL | GI | GIADR | RMDD | XEQZ | GLL |
| 0101 | GD | GD | SUB | ROL | GD | FP | WLM | SHOUT | GLLGDD |
| 0110 | GR | GR | ADD | SHLC | GR | NONE | RHYP | INTP | GLRCRY |
| 0111 | GL | GL | AD1 | ROLC | GL | NONE | WHYP | NMTP | GDDEC |
| 1000 | ACS | ACS | ADC | LSHR | ACS | NONE | RIO | XNEG | GIINC |
| 1001 | ACD | ACD | SUB | ROR | ACD | SP | WIO | IOSKP | GIAINC |
| 1010 | BONE | PCE | ADD | SHRC | PCE | GDADR | RLCL | DCRY | IR5TOI |
| 1011 | IRD | PCD | AD1 | RORC | PCE | SL | WLCL | SCRYB | HYPON |
| 1100 | IRESX | IREIO | ANC | SWAP | IRE | GIADR | MAPON | DCRYB | GRR |
| 1101 | BIT | LIT | ANC | SWAP | IRE | FP | XCT | CLEAR | GRRGDD |
| 1110 | ACSR | MONE | AND | SWAP | NOLD | NONE | MAPOFF | OVFLO | SETCRY |
| 1111 | ZERO | MONE | AND | SWAP | NOLD | NONE | ? | SET | GDADEC |

Appendix E (Continued)

| VCR | NAM | SPLA | D | CROS | CNAM | CNAMX | CNAMX | NAM | DEC |
|-----|-----|------|---|------|------|-------|-------|-----|-----|
| 0000 | NEXT | 0000 | N | 0000 | JUMP | NOP | WAITO | NEXT | NO |
| 0001 | JUMP | 0001 | Y | 0001 | CALL | SETA | WAIT1 | DECODE | YES |
| 0010 | SKIP | 0010 | | 0010 | FREPT | SETB | WAIT2 | TREPT | |
| 0011 | FSKIP | 0011 | | 0011 | IREPT | SETC | WAIT3 | FREPT | |
| 0100 | RTRN | 0100 | | 0100 | DECODE | CLRA | FLAGA | | |
| 0101 | CALL | 0101 | | 0101 | RTRN | CLRB | FLAGB | | |
| 0110 | ? | 0110 | | 0110 | RLNEXT | CLRC | FLAGC | | |
| 0111 | FJUMP | 0111 | | 0111 | RLNEXT | CLRX | FLAGC | | |
| 1000 | DECODE | 1000 | | 1000 | TJUMP | | | | |
| 1001 | IDCODE | 1001 | | 1001 | FJUMP | | | | |
| 1010 | SDCODE | 1010 | | 1010 | TCALL | | | | |
| 1011 | FDCODE | 1011 | | 1011 | FCALL | | | | |
| 1100 | TSKIP | 1100 | | 1100 | TRTRN | | | | |
| 1101 | TJUMP | 1101 | | 1101 | FRTRN | | | | |
| 1110 | TREPT | 1110 | | 1110 | RJUMP | | | | |
| 1111 | FREPT | 1111 | | 1111 | RJUMP | | | | |

**Claims**

1. A data processing system comprising a central processing unit (10) with a first control memory (31) and addressing means (33) therefor responsive to a macroinstruction to provide a sequence of first microinstructions, each including an address field (ADRH) and one or more modifier fields ($V_1$, $V_2$), a second control memory (32) responsive to each said address field to provide a second microinstruction (HROM 0—32) with a plurality of fields, and modifying means (34) responsive to the corresponding modifier field(s) to effect modification of the second macroinstructions, characterised in that the modifying means (34) substitute one or more of the fields (ABUS, BBUS, DEST) of selected second microinstructions by a modifier field ($V_1$, $V_2$) in accordance with a predetermined scheme of substitutions as specified by the substituted field or fields, in which scheme each modifier field selectively effects a plurality of different modifying substitutions.

2. A data processing system according to claim 1, characterised in that the or each modifier field ($V_1$, $V_2$) comprises a plurality of bits.

3. A data processing system in accordance with claim 1 or 2, characterized in that each first microinstruction contains a sequencing field (NAM) and in that the addressing means (33) for the first memory (31) are responsive to the sequencing field to select between a plurality of different modes of determining the next address for the first memory.

4. A data processing system in accordance with claim 3, characterised in that the sequencing means (33) comprises a sequencer program counter (100) for supplying the address information (VPC 0—8) and a multiplexer (101) responsive to a plurality of input control signals including the sequencing field (NAM) for providing a selected control output signal for controlling the operation of the sequencer program counter.

5. A data processing system in accordance with any of claims 1 to 4, characterised by decode control logic (40) responsive to each macroinstruction to initiate the sequence of first microinstructions by providing the first of these first microinstructions together with address information for the addressing means (33) establishing the address of the next first microinstruction.

6. A data processing system in accordance with any of claims 1 to 5, characterised in that the first memory (31) is a read-only memory.

7. A data processing system in accordance with any of claims 1 to 6, characterised in that the second memory (32) is a read-only memory.

8. A data processing system in accordance with any of claims 1 to 7, characterised in that the modification means (34) comprises one or more multiplexers (105) each responsive to a selected field of the second microinstructions (HROM 0—32) and to a selected one of the modifier fields $(V_1, V_2)$ to select therebetween.

**Patentansprüche**

1. Datenverarbeitungssystem, enthaltend eine zentrale verarbeitungseinheit mit einem ersten Kontrollspeicher (31) und einer Adressiereinheit (33) dafür, die auf einen Makrobefehl anspricht und eine Sequenz von ersten Mikrobefehlen bereitstellt, die je ein Adressenfeld (ADRH) und ein oder mehrere Modifizierfelder $(V_1, V_2)$ enthalten, einem zweiten Kontrollspeicher (32), der auf jedes der Adressenfelder anspricht und einen zweiten Mikrobefehl (HROM 0—32) mit einer Vielzahl von Feldern bereitstellt, und einer Modifiziereinheit (34), die auf das (die) Modifizierfeld(er) anspricht und die zweiten Mikrobefehle modifiziert, dadurch gekennzeichnet, daß die Modifiziereinheit (34) eines oder mehrere Felder (ABUS, BBUS, DEST) ausgewählter zweiter Mikrobefehle durch ein Modifizierfeld $(V_1, V_2)$ ersetzt entsprechend einem vorgegebenen Schema von Substitutionen, das durch das (die) ersetzte(n) Feld(er) festgelegt ist, wobei in dem Schema jedes Modifizierfeld selektiv eine Vielzahl verschiedener modifizierender Substitutionen bewirkt.

2. Datenverarbeitungssystem nach Anspruch 1, dadurch gekennzeichnet, daß das oder jedes Modifizierfeld $(V_1, V_2)$ eine Vielzahl von Bits enthält.

3. Datenverarbeitungssystem nach Anspruch 1 oder 2, dadurch gekennzeichnet, daß jeder erste Mikrobefehl ein Sequenzierfeld (NAM) aufweist und daß die Adressiereinheit (33) für den ersten Speicher (31) auf das Sequenzierfeld anspricht und zwischen einer Vielzahl verschiedener Arten für die Bestimmung der nächsten Adresse für den ersten Speicher auswählt.

4. Datenverarbeitungssystem nach Anspruch 3, dadurch gekennzeichnet, daß die Sequenziereinheit (33) einen Sequenzprogrammzähler (100) zur Lieferung der Adresseninformation (VPC 0—8) und einen Multiplexer (101) enthält, der auf eine Vielzahl von Eingangssteuersignalen einschließlich des Sequenzierfeldes (NAM) anspricht und ein ausgewähltes Ausgangssteuersignal für die Steuerung des Betriebs des Sequenzprogrammzählers bereitstellt.

5. Datenverarbeitungssystem nach einem der Ansprüche 1 bis 4, gekennzeichnet durch eine Dekodiersteuerlogik (40), die auf jeden Makrobefehl anspricht und die Sequenz der ersten Mikrobefehle einleitet, indem sie den ersten der ersten Mikrobefehle zusammen mit einer Adresseninformation für die Adresssiereinheit (33) bereitstellt, welche die Adresse für den nächsten Mikrobefehl herstellt.

6. Datenverarbeitungssystem nach einem der Ansprüche 1 bis 5, dadurch gekennzeichnet, daß der erste Speicher (31) ein Read-Only-Speicher ist.

7. Datenverarbeitungssystem nach wenigstens einem der Ansprüche 1 bis 6, dadurch gekennzeichnet, daß der zweite Speicher (32) ein Read-Only-Speicher ist.

8. Datenverarbeitungssystem nach wenigstens einem der Ansprüche 1 bis 7, dadurch gekennzeichnet, daß die Modifiziereinheit (34) einen oder mehrere Multiplexer (105) aufweist, von denen jeder auf ein ausgewähltes Feld der zweiten Mikrobefehle (HROM 0—32) und ein ausgewähltes Modifizierfeld $(V_1, V_2)$ anspricht, um zwischen diesen zu wählen.

**Revendications**

1. Système de traitement de données comprenant une unité centrale de traitement (10) possédant une première mémoire de commande (31) et des moyens d'adressage (33) prévus pour cette mémoire et répondant à une macro-instruction en délivrant une suite de premières micro-instructions, dont chacune contient une zone d'adresses (ADRH) et une ou plusieurs zones d'index $(V_1, V_2)$, une seconde mémoire de commande (32) répondant à chacune desdites zones d'adresse en délivrant une seconde micro-instruction (HROM 0—32), comprenant une pluralité de zones, et des moyens de modification (34) répondant à la ou aux zones d'index correspondantes de manière à réaliser la modification des secondes macro-instructions, caractérisé en ce que les moyens de modification (34) remplacent une ou plusieurs des zones (ABUS, BBUS, DEST) de secondes microinstructions sélectionnées, par une zone d'index $(V_1, V_2)$ conformément à un code prédéterminé de substitution, tel que spécifié par la ou les zones remplacées et dans lequel chaque zone d'index réalise de façon sélective plusieurs différentes substitutions de modification.

2. Système de traitement de données selon la revendication 1, caractérisé en ce que la ou chaque zone d'index $(V_1, V_2)$ comporte une pluralité de bits.

3. Système de traitement de données selon la revendication 1 ou 2, caractérisé en ce que chaque première microinstruction contient une zone de classement (NAM) et que les moyens d'adressage (33) pour la première mémoire (31) répondent à la zone de classement de manière à établir une sélection entre une pluralité de modes différents de détermination de l'adresse suivante pour la première mémoire.

4. Système de traitement de données selon la revendication 3, caractérisé en ce que les moyens de classement (33) comprennent un compteur de programmes de classement (100) pour l'envoi de l'information d'adresse (VPC 0—8) et un multiplexeur (101) répondant à une pluralité de signaux de commande d'entrée incluant la zone de classement (NAM) pour délivrer un signal de sortie de commande sélectionné servant à commander le fonctionnement du compteur de programmes de classement.

5. Système de traitement de données selon l'une quelconque des revendications 1 à 4, caractérisé par une logique de commande de décodage (40) répondant à chaque microinstruction de manière à déclencher la séquence des premières micro-instructions en délivrant la première de ces premières micro-instructions ainsi qu'une information d'adresse pour les moyens d'adressage (33), ce qui établit l'adresse de la première micro-instruction suivante.

6. Système de traitement de données selon l'une quelconque des revendications 1 à 5, caractérisé en ce que la première mémoire (31) est une mémoire morte.

7. Système de traitement de données selon l'une quelconque des revendications 1 à 6, caractérisé en ce que la seconde mémoire (32) est une mémoire morte.

8. Système de traitement de données selon l'une quelconque des revendications 1 à 7, caractérisé en ce que les moyens de modification (34) comprennent un ou plusieurs multiplexeurs (105) répondant chacun à une zone sélectionnée des secondes micro-instructions (HROM 0—32) et à une zone sélectionnée faisant partie des zones d'index ($V_1$, $V_2$) de manière à établir une sélection entre ces zones.

FIG. I

FIG.2

FIG.3

MICRO-MODIFICATION UNIT 34

FIG.4